# EUROPÄISCHE PATENTSCHRIFT

(11) **EP 0 944 920 B1**
(45) Veröffentlichungstag und Bekanntmachung des Hinweises auf die Patenterteilung: **31.10.2001**
(21) Anmeldenummer: 97937458.4
(22) Anmeldetag: 14.08.1997
(51) Int. Cl.: H01L 21/78, H01L 23/31

(54) **VERFAHREN ZUM TRENNEN EINER HALBLEITERSCHEIBE**
PROCESS FOR DIVIDING A SEMICONDUCTOR WAFER
PROCEDE POUR DIVISER UNE TRANCHE DE SEMICONDUCTEURS

(30) Priorität: 14.08.1996 DE 19632815
(43) Veröffentlichungstag der Anmeldung: 29.09.1999
(73) Patentinhaber: Osram Opto Semiconductors GmbH & Co. OHG, 93049 Regensburg (DE)
(72) Erfinder: LANG, Gisela, D-93057 Regensburg (DE); MAURER, Josef, D-93186 Pettendorf (DE)
(74) Vertreter: Epping, Wilhelm, Dipl.-Ing.
(86) Internationale Anmeldenummer: DE9701756
(87) Internationale Veröffentlichungsnummer: WO9807190

(56) Entgegenhaltungen:
- EP-A- 0 661 737
- DE-A- 3 335 395
- US-A- 5 171 716
- JP-A-61 180 442

## Beschreibung

Die Erfindung bezieht sich auf ein Verfahren zum Trennen einer mit einer Vielzahl von optoelektronischen Halbleiterstrukturen versehenen Halbleiterscheibe in eine Anzahl von Einzelchips durch Trennschleifen vermittels einem Schneidwerkzeug, wobei Schneidwerkzeug und Halbleiterscheibe relativ zueinander entlang von Schneidspuren geführt werden.

Halbleiterscheiben können je nach Chip- und Scheibengröße eine große Anzahl von Einzelchips enthalten, die vor der Montage getrennt bzw. vereinzelt werden müssen. Das heute fast ausschließlich angewandte Trennverfahren für integrierte Schaltungen ist das Sägen, genauer gesagt das Trennschleifen, welches mit Abstand die genauesten und saubersten Chipkanten liefert und im Gegensatz zu Ritz- bzw. Brechverfahren unabhängig von der Kristallorientierung der Halbleiterscheibe gute Ergebnisse liefert. Das Prinzip des Trennschleifverfahrens beruht darauf, dass die Halbleiterscheibe auf einem in X-Richtung verfahrbaren Tisch befestigt und unter einer hochtourig drehenden Diamantschleifscheibe hindurch bewegt wird. Zur Vermeidung einer Beeinträchtigung der elektronischen und optischen Eigenschaften der Diodenstrukturen nach Durchführung des Trennschleifprozesses ist die Erzeugung möglichst sauberer Seitenkanten der vereinzelten Chips erforderlich. Insbesondere bei Halbleiterscheiben (Wafer) mit einem III-V-Halbleiter-Grundmaterial werden nach dem Vereinzeln durch Trennschleifen üblicherweise die so erzeugten Chipflanken nass-chemisch geätzt, um das beim Trennschleifen erzeugte Kristalldamage zu entfernen. Dies ist insbesondere bei Lumineszenzdioden erforderlich, um zum Einen die Lichtauskopplung zu verbessern, und zum Anderen Kristallschäden, die im Betrieb aufgrund des beim Trennen erzeugten Damage induziert werden und die Lebensdauer der Lumineszenzdiode verkürzen, zu vermeiden. Um zu verhindern, dass beim Chipflankenätzen auch die Halbleiteroberflächen mit der partiell vorhandenen, strukturierten Vorderseiten-Kontaktmetallisierung angeätzt werden, muss diese Oberfläche geschützt werden. Bisher wurden die beim Vereinzeln durch Trennschleifen verursachten Schädigungen der Diodenstrukturen dadurch vermindert, dass vor dem Vereinzeln auf der Halbleiterscheibe eine ganzflächig aufgebrachte Schutzschicht aus Photolack vorgesehen wurde, die mindestens so dick sein musste, dass die Vorderseitenmetallisierung auch an den Kanten abgedeckt ist. Diese Photolack-Schutzschicht musste allerdings beim Vereinzeln ebenfalls durchtrennt werden. Dadurch werden die Spanräume der Diamantschleifwerkzeuge, mit denen der Trennschleifprozess durchgeführt wird, zum Teil zugesetzt. Dies führte insbesondere bei den III-V-Materialien GaAlAs und InP zu einer deutlich schlechteren Trennschleifqualität verglichen mit einer Halbleiteroberfläche ohne zu durchtrennende Photolackabtrennung.

JP-A- 61 180 442 offenbart ein Verfahren zum Trennen einer Halbleiterscheibe in eine Anzahl von Einzelchips.

Der Erfindung liegt die Aufgabe zugrunde, ein Verfahren zum Trennen einer mit einer Vielzahl von optoelektronischen Halbleiterbauelement-Strukturen, insbesondere Diodenstrukturen versehenen Halbleiterscheibe in eine Anzahl von Einzelchips durch Trennschleifen vermittels einem Schneidwerkzeug anzugeben, bei dem Beeinträchtigungen des Trennschleifergebnisses durch die für das spätere Chipflankenätzen notwendige Vorderseitenabdeckung vermieden werden können.

Diese Aufgabe wird durch ein Verfahren gemäß Anspruch 1 gelöst.

Das erfindungsgemäße Verfahren zeichnet sich durch folgende Schritte aus:
- Ganzflächiges Abscheiden einer Abdeckschicht auf der Oberfläche der mit den optoelektronischen Halbleiterstrukturen versehenen Halbleiterscheibe;
- Strukturieren der Abdeckschicht dergestalt, dass an den Bereichen von Schneidspuren die Abdeckschicht entfernt wird; und
- Trennen der Halbleiterscheibe in die Anzahl von Einzelchips durch Trennschleifen vermittels einem Schneidwerkzeug, wobei das Schneidwerkzeug und die Halbleiterscheibe relativ zueinander entlang der Schneidspuren geführt werden.

Dadurch, dass die Abdeckschicht entlang der Schneidspuren, an denen später der Trennschleifprozess durchgeführt wird, entfernt wird, kommt das Schneidwerkzeug beim Trennschleifen nicht in Kontakt mit dem Material der Abdeckschicht, und das Trennschleifergebnis wird nicht beeinträchtigt.

Die Chipflanken werden nach dem Trennen der Halbleiterscheibe angeätzt, wobei die Chipoberfläche durch die Abdeckschicht vor einem Angriff des verwendeten Ätzmittels geschützt bleibt.

Bei einer besonders bevorzugten Ausführung der Erfindung ist vorgesehen, dass die Abdeckschicht aus einem Photolackmaterial besteht, und die Strukturierung der Abdeckschicht durch einen phototechnischen Belichtungsprozess vermittels einer Photomaske und einem nachfolgenden Entwicklungsprozess durchgeführt wird. Die ganzflächige Abscheidung und die phototechnischen Belichtungs- und Entwicklungsprozesse des Photolackes kann hierbei nach an sich bekannten Halbleiterstandard-Prozessschritten unter Verwendung einer geeignet strukturierten Photomaske erfolgen.

Damit die auf der Hauptoberfläche der Halbleiterscheibe aufgebrachte Vorderseitenmetallisierung auch an den Kanten vollständig abgedeckt ist, ist es von Vorteil, wenn die Dicke der ganzflächig abgeschiedenen Abdeckschicht wenigstens etwa 5 µm beträgt.

Das erfindungsgemäße Verfahren findet insbesondere bei III-V-Halbleitermaterialien Anwendung, insbesondere bei der Herstellung von Lumineszenzdioden.

Weitere Merkmale, Vorteile und Zweckmäßigkeiten der Erfindung ergeben sich aus der nachfolgenden Beschreibung eines Ausführungsbeispiels anhand der Zeichnung. Es zeigt:
- Figur 1: eine schematische Schnittansicht einer Halbleiterscheibe vor dem Vereinzeln der Halbleiterchips;
- Figur 2: eine schematische Schnittansicht der Halbleiterscheibe während des Trennschleifprozesses vermittels einem Schneidwerkzeug; und
- Figur 3: eine schematische Schnittansicht der Halbleiterscheibe nach dem Vereinzeln und Chipflankenätzen.

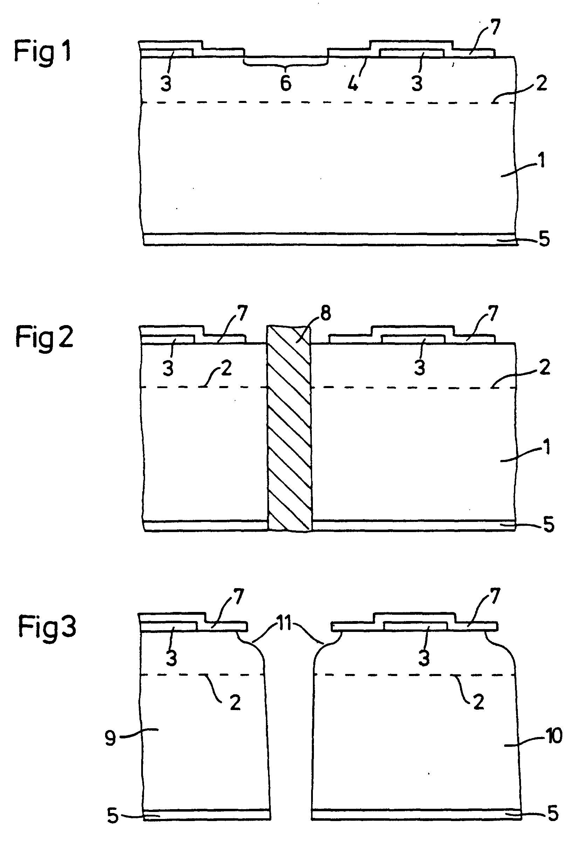

Figur 1 zeigt schematisch einen Ausschnitt einer mit einer Vielzahl von Diodenstrukturen versehenen Halbleiterscheibe 1 vor dem Trennen in die Anzahl von Einzelchips. Die Halbleiterscheibe 1 besteht aus einem III-V-Halbleitergrundmaterial wie insbesondere GaAlAs oder InP, in welchem Lumineszenzdioden mit einem schematisch angedeuteten pn-Übergang 2 ausgebildet sind. Die Bezugsziffer 3 bezeichnet schematisch die auf der Hauptoberfläche 4 der Halbleiterscheibe ausgebildete Vorderseitenmetallisierung, das Bezugszeichen 5 eine auf der rückseitigen Oberfläche der Halbleiterscheibe abgeschiedene Rückseitenmetallisierung. Der mit dem Bezugszeichen 6 gekennzeichnete Bereich der Hauptoberfläche 4 der Halbleiterscheibe 1 bezeichnet die Schneidspuren, entlang denen beim späteren Trennschleifprozess die Halbleiterscheibe 1 und das Schneidwerkzeug relativ zueinander geführt werden. Auf der Hauptoberfläche 4 der mit den Diodenstrukturen versehenen Halbleiterscheibe 1 wird ganzflächig eine Photolackschicht 7 abgeschieden, vorzugsweise im Schleuderverfahren, und vermittels einer entsprechend ausgebildeten Photomaske nach Halbleiterstandardverfahren phototechnisch belichtet, anschließend entwickelt, und danach entlang der Schneidspuren 6, an denen später der Trennschleifprozess durchgeführt wird, entfernt.

Figur 2 zeigt den nachfolgenden Trennschleifprozeß vermittels einer Diamantschleifscheibe 8, welche wie dargestellt entlang der Schneidspuren 6 im Sinne einer vollständigen Durchtrennung der Halbleiterscheibe 1 geführt wird. Aus der Figur 2 ist ohne weiteres ersichtlich, dass die Diamantschleifscheibe 8 beim Trennschleifprozess nicht in Kontakt mit der Photolackschicht 7 gelangt, wodurch das Trennschleifergebnis nicht beeinträchtigt wird.

Figur 3 zeigt schließlich die nach Durchführung des Trennschleifprozesses sowie anschließendem Ätzen der Chipflanken 11 vereinzelten Halbleiterchips 9 und 10.

### Bezugszeichenliste

- 1: Halbleiterscheibe
- 2: pn-Übergang
- 3: Vorderseitenmetallisierung
- 4: Hauptoberfläche
- 5: Rückseitenmetallisierung
- 6: Schneidspuren
- 7: Photolackschicht
- 8: Diamantschleifscheibe
- 9, 10: Halbleiterchips
- 11: geätzte Chipflanke

## Patentansprüche

1. Verfahren zum Trennen einer mit einer Vielzahl von optoelektronischen Halbleiterstrukturen versehenen Halbleiterscheibe (1) in eine Anzahl von Einzelchips (9, 10) durch Trennschleifen, mit den Schritten:
- Ganzflächiges Abscheiden einer Abdeckschicht (7) auf der Oberfläche (4) der mit den optoelektronischen Halbleiterstrukturen versehenen Halbleiterscheibe (1);
- Strukturieren der Abdeckschicht (7) dergestalt, dass an den Bereichen von Schneidspuren (6) die Abdeckschicht (7) entfernt wird;
- Trennen der Halbleiterscheibe (1) in die Anzahl von Einzelchips (9, 10) durch Trennschleifen vermittels einem Schneidwerkzeug, wobei das Schneidwerkzeug und die Halbleiterscheibe (1) relativ zueinander entlang der Schneidspuren (6) geführt werden;
- Anätzen der Chipflanken (11) nach dem Trennen der Halbleiterscheibe (1); und
- Entfernen der Abdeckschicht (7).

2. Verfahren nach Anspruch 1, bei dem die Abdeckschicht aus einem Photolackmaterial besteht, und die Strukturierung der Abdeckschicht durch einen phototechnischen Belichtungsprozess vermittels einer Photomaske und einem nachfolgenden Entwicklungsprozess durchgeführt wird.

3. Verfahren nach Anspruch 1 oder 2, bei dem die Dicke der ganzflächig abgeschiedenen Abdeckschicht (7) wenigstens etwa 5 µm beträgt.

4. Verfahren nach Anspruch 1 bis 3, bei dem die Halbleiterscheibe (1) als Grundmaterial einen III-V-Halbleiter, insbesondere GaAlAs oder InP aufweist.

5. Verfahren nach einem der Ansprüche 1 bis 4,bei dem die in der Halbleiterscheibe (1) gefertigten Diodenstrukturen insbesondere Lumineszenzdioden aufweisen.

## Claims

1. Method for cutting a semiconductor wafer (1) which is provided with a multiplicity of optoelectronic semiconductor structures into a number of individual chips (9, 10) by abrasive cutting, comprising the following steps:
- deposition of a covering layer (7) over the entire surface (4) of the semiconductor wafer (1) which is provided with the optoelectronic semiconductor structures;
- structuring of the covering layer (7) in such a manner that the covering layer (7) is removed at the areas of cutting tracks (6);
- cutting the semiconductor wafer (1) into the number of individual chips (9, 10) by abrasive cutting by means of a cutting tool, the cutting tool and the semiconductor wafer (1) being guided, relative to one another, along the cutting tracks (6);
- etching of the chip flanks (11) after the semiconductor wafer (1) has been cut; and
- removing the covering layer (7).

2. Method according to Claim 1, in which the covering layer comprises a photoresist material, the covering layer is structured by a phototechnical exposure process by means of a photomask and a subsequent developing process.

3. Method according to Claim 1 or 2, in which the thickness of the covering layer (7) which has been deposited over the entire surface is at least approximately 5 µm.

4. Method according to Claims 1 to 3, in which the semiconductor wafer (1) has, as its basic material, a III-V semiconductor, in particular GaAlAs or InP.

5. Method according to one of Claims 1 to 4, in which the diode structures produced in the semiconductor wafer (1) have, in particular, light-emitting diodes.

## Revendications

1. Procédé de division d'une tranche (1) de semi-conducteur munie d'une pluralité de structures optoélectroniques à semi-conducteur en un certain nombre de puces (9, 10) individuelles par tronçonnage par abrasion, comprenant les stades:
- de dépôt sur toute la surface d'une couche (7) de recouvrement sur la surface (4) de la tranche (1) de semi-conducteur munie de structures optoélectroniques à semi-conducteur ;
- de structuration de la couche (7) de recouvrement, de façon à éliminer la couche (7) de recouvrement sur les zones de traces (6) de coupe ;
- de division de la tranche (1) de semi-conducteur en le certain nombre de puces (9, 10) individuelles par tronçonnage par abrasion au moyen d'un outil de coupe, l'outil de coupe et la tranche (1) de semi-conducteur étant guidés relativement l'un à l'autre le long des traces (6) de coupe ;
- d'attaque chimique des flancs (11) des puces après la division de la tranche (1) de semi-conducteur ; et
- d'élimination de la couche (7) de recouvrement.

2. Procédé suivant la revendication 1, dans lequel la couche de recouvrement est en une matière formant vernis photosensible et la structuration de la couche de recouvrement est effectuée par une opération d'exposition phototechnique au moyen d'un masque photographique et d'une opération venant ensuite de développement.

3. Procédé suivant la revendication 1 ou 2, dans lequel l'épaisseur de la couche (7) de recouvrement déposée sur toute la surface est au moins d'environ 5 µm.

4. Procédé suivant la revendication 1 à 3, dans lequel la tranche (1) de semi-conducteur a, comme matériau de base, un semi-conducteur III-V, notamment GaAIAs ou InP.

5. Procédé suivant l'une des revendications 1 à 4, dans lequel les structures de diodes fabriquées dans la tranche (1) de semi-conducteur ont notamment des diodes luminescentes.
